(19) Europäisches Patentamt
European Patent Office
Office européen des brevets

(11) **EP 3 183 815 B1**

(12) **EUROPÄISCHE PATENTSCHRIFT**

(45) Veröffentlichungstag und Bekanntmachung des Hinweises auf die Patenterteilung:
**03.04.2024 Patentblatt 2024/14**

(21) Anmeldenummer: **15739279.6**

(22) Anmeldetag: **20.07.2015**

(51) Internationale Patentklassifikation (IPC):
*H03H 9/54* *(2006.01)*     *H03H 9/56* *(2006.01)*
*H03H 9/60* *(2006.01)*     *H03H 9/64* *(2006.01)*
*H03H 9/70* *(2006.01)*     *H03H 9/72* *(2006.01)*
*H03H 9/02* *(2006.01)*

(52) Gemeinsame Patentklassifikation (CPC):
**H03H 9/542; H03H 9/568; H03H 9/605; H03H 9/6483; H03H 9/706; H03H 9/725;** H03H 2009/02165

(86) Internationale Anmeldenummer:
**PCT/EP2015/066552**

(87) Internationale Veröffentlichungsnummer:
**WO 2016/026634 (25.02.2016 Gazette 2016/08)**

(54) **DUPLEXER MIT ABSTIMMBAREN HF-FILTERN**

DUPLEXER WITH TUNABLE HF FILTERS

DUPLEXEUR AVEC FILTRES HF ACCORDABLES

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **20.08.2014 DE 102014111909**

(43) Veröffentlichungstag der Anmeldung:
**28.06.2017 Patentblatt 2017/26**

(73) Patentinhaber: **SnapTrack, Inc.**
**San Diego, CA 92121 (US)**

(72) Erfinder: **SCHMIDHAMMER, Edgar**
**83371 Stein an der Traun (DE)**

(74) Vertreter: **Bardehle Pagenberg Partnerschaft mbB**
**Patentanwälte Rechtsanwälte**
**Prinzregentenplatz 7**
**81675 München (DE)**

(56) Entgegenhaltungen:
EP-A1- 2 530 838          EP-A2- 0 949 756
EP-A2- 1 035 648          WO-A1-99/23757
WO-A2-2012/079038

• CARPENTIER J ET AL: "A Tunable Bandpass BAW-Filter Architecture and Its Application to WCDMA filter", 2005 IEEE MTT-S INTERNATIONAL MICROWAVE SYMPOSIUM, PISCATAWAY, NJ, USA,IEEE, 12. Juni 2005 (2005-06-12), Seiten 221-224, XP010844727, DOI: 10.1109/MWSYM.2005.1516564 ISBN: 978-0-7803-8846-8
• RICHARD J CAMERON: "Advanced Filter Synthesis", IEEE MICROWAVE MAGAZINE, IEEESERVICE CENTER, PISCATAWAY, NJ, US, vol. 12, no. 6, 1 October 2011 (2011-10-01), pages 42-61, XP011382820, ISSN: 1527-3342, DOI: 10.1109/MMM.2011.942007

## Beschreibung

Die Erfindung betrifft Duplexer, die z.B. in tragbaren Kommunikationsgeräten Verwendung finden können.

Tragbare Kommunikationsgeräte, z.B. Mobilfunkgeräte, können mittlerweile Kommunikation in einer Vielzahl unterschiedlicher Frequenzbänder und bei einer Vielzahl unterschiedlicher Übertragungssysteme ermöglichen. Dazu umfassen sie i.A. eine Vielzahl an HF-Filtern, die jeweils für die entsprechende Frequenz und das entsprechende Übertragungssystem vorgesehen sind. Zwar können moderne HF-Filter inzwischen mit kleinen Abmessungen hergestellt werden. Aufgrund ihrer Vielzahl und der Komplexität ihrer Verschaltung sind die Frontend-Module, in denen die Filter angeordnet sind, dennoch relativ groß und ihre Herstellung aufwändig und teuer.

Abhilfe könnten abstimmbare HF-Filter bringen. Solche Filter haben eine Mittenfrequenz, die einstellbar ist, weshalb ein abstimmbares Filter prinzipiell zwei oder mehr konventionelle Filter ersetzen kann. Abstimmbare HF-Filter sind z.B. aus den Druckschriften US 2012/0313731 A1 oder EP 2 530 838 A1 bekannt. Dabei werden die elektroakustischen Eigenschaften von mit akustischen Wellen arbeitenden Resonatoren durch abstimmbare Impedanzelemente verändert.

Aus dem Beitrag "Reconfigurable Multiband SAW Filters for LTE Applications", IEEE SiRF 2013, S. 153-155, von Lu et al. sind mittels Schalter rekonfigurierbare Filter bekannt.

Die WO 99/23757 A1 beschreibt einen akustischen Wellenfilter in Leiterstruktur mit verlustbehafteten Induktivitäten, welche mit Resonatoren parallel geschaltet sind.

Die EP 1035648 A2 beschreibt abstimmbare HF-Filter und einen Duplexer, der diese Filter umfasst.

Problematisch an bekannten abstimmbaren HF-Filtern ist jedoch insbesondere, dass das Abstimmen selbst wichtige Eigenschaften der Filter verändert. So ändern sich beim Abstimmen z. B. die Einfügedämpfung, die Eingangsimpedanz und/oder die Ausgangsimpedanz.

Es ist deshalb eine Aufgabe, einen Duplexer mit HF-Filtern anzugeben, die ein Abstimmen ohne Veränderung anderer wichtiger Parameter ermöglichen und die dem Fachmann zusätzliche Freiheitsgrade beim Entwerfen von Filtermodulen zur Verfügung stellen.

Diese Aufgaben werden durch einen Duplexer mit HF-Filtern gemäß der beanspruchten Erfindung gelöst, wie sie im unabhängigen Anspruch 1 definiert ist. Weitere Ausführungsformen der beanspruchten Erfindung werden in den abhängigen Ansprüchen beschrieben.

Weitere "Aspekte", "Ausführungsformen", "Beispiele", usw., die im Folgenden beschrieben werden und nicht in den Bereich der so definierten Erfindung fallen, sind als technische Hintergrundinformationen aufzufassen, die das Verständnis der beanspruchten Erfindung fördern sollen.

Das HF-Filter umfasst in Serie verschaltete Grundglieder mit jeweils einem elektroakustischen Resonator. Das Filter umfasst ferner in Serie zwischen den Grundgliedern verschaltete Impedanzwandler. Die Impedanzwandler sind Impedanz-Inverter. Die Resonatoren der Grundglieder sind nur Serienresonatoren. Zumindest einer der Resonatoren ist abstimmbar.

Grundglieder in HF-Filtern sind z.B. aus Ladder-type Strukturen bekannt, wo ein Grundglied einen Serienresonator und einen Parallelresonator umfasst. Mehrere solcher Grundglieder hintereinandergeschaltet bewirken im Wesentlichen die Filterwirkung, falls die Resonanzfrequenzen und die Antiresonanzfrequenzen der Serien- bzw. Parallelresonatoren geeignet aufeinander abgestimmt sind.

Die hier vorliegenden Grundglieder können insofern in etwa als halbierte Grundglieder einer Ladder-type Schaltung aufgefasst werden.

Als Impedanzwandler kommen Impedanz-Inverter oder Admittanz-Inverter in Frage. Während ein Impedanzwandler eine beliebige Transformation einer Last-Impedanz in eine Eingangsimpedanz transformiert, ist die Wirkung der Impedanz-Inverter bzw. Admittanz-Inverter deutlich konkretisiert. Impedanz-Inverter bzw. Admittanz-Inverter können wie folgt mit den Hilfsmitteln für Zweitore beschrieben werden.

Die Kettenmatrix mit den Matrixelementen A, B, C, D beschreibt die Wirkung eines Zweitores, das mit seinem Ausgangstor an eine Last angeschlossen ist, indem sie vorgibt, wie eine an einer Last anfallende Spannung $U_L$ und ein durch eine Last fließender Strom $I_L$ in eine am Eingangstor anliegende Spannung $U_{IN}$ und eine in das Eingangstor fließender Strom $I_{IN}$ transformiert werden:

$$\begin{pmatrix} U_{IN} \\ I_{IN} \end{pmatrix} = \begin{pmatrix} A & B \\ C & D \end{pmatrix} \begin{pmatrix} U_L \\ I_L \end{pmatrix} \qquad (1)$$

Die Impedanz Z ist dabei als Verhältnis zwischen Spannung und Strom definiert:

$$Z = \frac{U}{I} \qquad (2)$$

Somit wird eine Last-Impedanz $Z_L$ in eine Eingangsimpedanz $Z_{IN}$ transformiert:

$$Z_{IN} = \frac{AZ_L + B}{CZ_L + D} \qquad (3)$$

Die Last-Impedanz $Z_L$ sieht von außen also wie die Eingangsimpedanz $Z_{IN}$ aus.

Ein Impedanz-Inverter ist nun durch folgende Kettenmatrix charakterisiert:

$$\begin{pmatrix} A & B \\ C & D \end{pmatrix}_K = \begin{pmatrix} 0 & iK \\ i/K & 0 \end{pmatrix} \qquad (4)$$

Daraus folgt

$$Z_{IN} = \frac{K^2}{Z_L} \qquad (5)$$

Die Impedanz wird invertiert. Der Proportionalitätsfaktor ist $K^2$.

Ein Admittanz-Inverter ist durch folgende Kettenmatrix charakterisiert:

$$\begin{pmatrix} A & B \\ C & D \end{pmatrix}_J = \begin{pmatrix} 0 & i/J \\ iJ & 0 \end{pmatrix} \qquad (6)$$

Daraus folgt für die Admittanz Y:

$$Y_{IN} = \frac{J^2}{Y_L} \qquad (7)$$

Die Admittanz wird invertiert. Der Proportionalitätsfaktor ist $J^2$.

Es wurde herausgefunden, dass ein gemeinsames Vorhandensein von Parallelresonatoren und Serienresonatoren deutliche Auswirkungen auf die Veränderlichkeit wichtiger Parameter beim Abstimmen des HF-Filters hat. Es wurde ferner herausgefunden, dass das Abstimmen weniger Einfluss auf diese Parameter ausübt, wenn nur eine Sorte von Resonatoren vorhanden ist. Sind also nur Serienresonatoren oder nur Parallelresonatoren vorhanden, verhält sich das HF-Filter beim Abstimmen stabiler bezüglich der Einfügedämpfung, der Eingangsimpedanz und/oder der Ausgangsimpedanz. Es wurde außerdem herausgefunden, dass die o.g. Impedanzwandler geeignet sind, Serienresonatoren als Parallelresonatoren und umgekehrt erscheinen zu lassen. Insbesondere eine Serienverschaltung aus zwei Impedanz-Invertern mit einem Serienresonator dazwischen sieht für seine Schaltungsumgebung wie ein Parallelresonator aus. Eine Serienverschaltung aus zwei Admittanz-Invertern mit einem Parallelresonator dazwischen sieht für seine Schaltungsumgebung wie ein Serienresonator aus.

Mit diesen Serienverschaltungen wird es deshalb möglich, HF-Filterschaltungen zu erstellen, die besser abstimmbar sind. Es ist deshalb möglich, das HF-Filter so auszugestalten, dass die Impedanzwandler Impedanz-Inverter und die Resonatoren Serienresonatoren sind.

Solche Filter benötigen keine Parallelresonatoren. Sind die Filter als Bandpassfilter oder als Bandsperrfilter ausgestaltet, so weisen diese i.A. eine steile rechte Flanke auf. Das Filter wird in einem Duplexer verwendet. Wegen der steilen rechten Flanke bevorzugt als Sendefilter. Nämlich dann, wenn das Sendeband unterhalb des Empfangsbands liegt. Sollte die relative Anordnung von Sendeband und Empfangsband vertauscht sein, ist das Filter mit Serienresonatoren bevorzugt im Empfangsfilter.

Es ist ferner auch möglich, das HF-Filter so auszugestalten, dass die Impedanzwandler Admittanz-Inverter und die Resonatoren Parallelresonatoren sind.

Solche Filter benötigen keine Serienresonatoren. Sind die Filter als Bandpassfilter oder als Bandsperrfilter ausgestaltet, so weisen diese i.A. eine steile linke Flanke auf. Das Filter wird in einem Duplexer verwendet. Wegen der steilen linken Flanke bevorzugt als Empfangsfilter. Nämlich dann, wenn das Empfangsband oberhalb des Sendebands liegt. Sollte die relative Anordnung von Sendeband und Empfangsband vertauscht sein, ist das Filter mit Serienresonatoren bevorzugt im Sendefilter.

Es ist möglich, dass die Impedanzwandler sowohl kapazitive Elemente als auch induktive Elemente als Impedanzelemente umfassen. Es ist aber auch möglich, dass die Impedanzwandler nur kapazitive Elemente oder nur induktive Elemente umfassen. Dann bestehen die Impedanzwandler nur aus passiven Schaltungselementen. Insbesondere, wenn die Impedanzwandler nur wenige oder gar keine induktiven Elemente umfassen, können sie leicht als strukturierte Metallisierungen in Metalllagen eines Mehrlagensubstrats realisiert sein.

Es ist möglich, dass die Impedanzwandler zusätzlich zu induktiven oder kapazitiven Elementen Phasenschieber-Leitungen umfassen. Es ist aber auch möglich, dass die Impedanzwandler aus Phasenschieber-Leitungen bestehen. Auch Phasenschieber-Leitungen können einfach und kompakt bauend in einem Mehrlagensubstrat integriert sein.

Es ist möglich, dass das Filter durch eine symmetrische Beschreibungsmatrix B beschrieben ist.

Es gibt Filterschaltungen, die durch eine Beschreibungsmatrix B vollständig beschrieben sind. Die Matrix B enthält Matrixelemente, die die einzelnen Schaltungskomponenten des Filters charakterisieren.

Eine Filterschaltung, die drei in Serie verschaltete Resonatoren R1, R2, R3 umfasst und eingangsseitig mit einer Quellimpedanz ZS und ausgangsseitig mit einer Lastimpedanz ZL verschaltet ist, hätte folgende Form:

$$B = \begin{pmatrix} Z_S & 0 & 0 & 0 & 0 \\ 0 & R_1 & 0 & 0 & 0 \\ 0 & 0 & R_2 & 0 & 0 \\ 0 & 0 & 0 & R_3 & 0 \\ 0 & 0 & 0 & 0 & Z_L \end{pmatrix} \qquad (8)$$

Als Bandpassfilter würde die Schaltung aber nicht arbeiten.

Werden die beiden äußeren Serienresonatoren durch Impedanz-Inverter so maskiert, dass sie jeweils als Parallelresonatoren erscheinen, wird eine Struktur erhalten, die sich wie eine Ladder-type Struktur verhält und die durch die folgende Beschreibungsmatrix beschrieben ist:

$$B = \begin{pmatrix} Z_S & K_{S1} & 0 & 0 & 0 \\ K_{S1} & R_1 & K_{12} & 0 & 0 \\ 0 & K_{12} & R_2 & K_{23} & 0 \\ 0 & 0 & K_{23} & R_3 & K_{3L} \\ 0 & 0 & 0 & K_{3L} & Z_L \end{pmatrix} \qquad (9)$$

Dabei steht $K_{S1}$ für den Impedanz-Inverter zwischen der Quell-Impedanz $Z_S$ und dem ersten Resonator. $K_{12}$ steht für den Impedanz-Inverter zwischen dem ersten und dem zweiten Resonator.

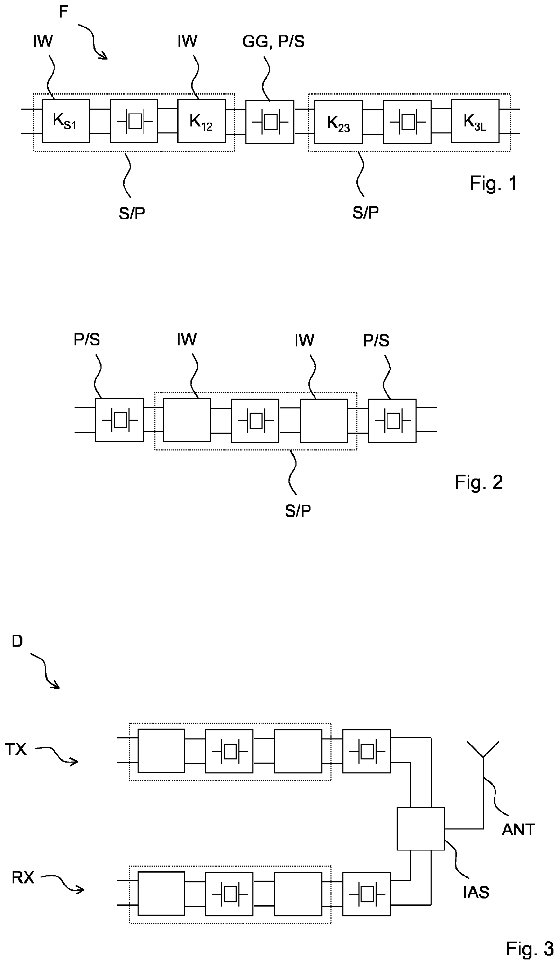

I.A. bezeichnen die Indices der Größen der Inverter die Resonatoren, zwischen denen die entsprechenden Inverter angeordnet sind. Es gilt $B_{ij} = B_{ji}$, d.h. die Matrix ist symmetrisch bezüglich ihrer Diagonalen. Die zur Gleichung (9) gehörige Filterschaltung ist in Figur 1 gezeigt. Die Resonatoren werden durch Größen auf der Diagonalen der Matrix beschrieben. Die Impedanzwandler werden durch Größen auf den Nebendiagonalen direkt oberhalb und unterhalb der Diagonalen beschrieben.

Es ist möglich, dass das Filter einen zweiten Impedanzwandler, der zu einem Segment des Filters parallel geschaltet ist, umfasst. Das Segment beinhaltet eine Serienschaltung mit einem Grundglied und zwei Impedanzwandlern.

Die Beschreibungsmatrix enthält dann Einträge, die oberhalb der oberen bzw. unterhalb der unteren Nebendiagonale stehen.

Zumindest einer der Resonatoren der Grundglieder ist abstimmbar. Prinzipiell und insbesondere, wenn einer der Resonatoren abstimmbar ist, kommen BAW-Resonatoren (BAW = Bulk Acoustic Wave = akustische Volumenwelle), SAW-Resonatoren (SAW = Surface Acoustic Wave = akustische Oberflächenwelle), GBAW-Resonatoren (GBAW = Guided Bulk Acoustic Wave = geführte akustische Volumenwelle) und/oder LC-Resonatoren in Frage. Mit akustischen Wellen arbeitende Resonatorelemente haben im Wesentlichen ein Ersatzschaltbild mit einer Parallelschaltung aus einem kapazitiven Element $C_0$ einerseits und einer Serienschaltung mit einem induktiven Element $L_1$ und einem kapazitiven Element $C_1$ andererseits. Ein solches Resonatorelement hat seine Resonanzfrequenz bei

$$\omega_0 = \sqrt{\frac{1}{L_1 C_1}} \qquad\qquad (10)$$

und seine Antiresonanzfrequenz bei

$$\omega_p = \omega_0 \sqrt{1 + \frac{C_1}{C_0}} = \sqrt{\frac{1}{L_1 C_1}} \sqrt{1 + \frac{C_1}{C_0}} \qquad\qquad (11)$$

Umfasst der Resonator neben dem Resonatorelement noch abstimmbare Element wie abstimmbare induktive oder kapazitive Elemente, die in Serie und/oder parallel zum Resonatorelement geschaltet sind, so wird ein Resonator mit veränderlichem Frequenzverhalten gebildet. Die Resonanzfrequenz hängt dabei von $L_1$ und $C_1$ aber nicht von $C_0$ ab. Die Antiresonanz hängt zusätzlich von $C_0$ ab. Durch Variation der Impedanz der abstimmbaren Impedanzelemente können $C_0$ und $L_1$ des Ersatzschaltbilds unabhängig voneinander variiert werden. Damit können die Resonanzfrequenz und die Antiresonanzfrequenz unabhängig voneinander eingestellt werden.

Alternativ zu Resonatoren mit Resonatorelementen, deren charakteristische Frequenzen mittels abstimmbarer Impedanzelemente variierbar sind oder zusätzlich dazu kann ein abstimmbarer Resonator ein Feld aus Resonatorelementen umfassen, von denen jedes Element mittels Schalter zum Resonator koppelbar oder vom Resonator trennbar ist. Es handelt sich dann um ein Array aus m Resonatorelementen pro abstimmbarem Resonator. Damit lassen sich HF-Filter bauen, die - je nach aktuell aktivem Resonatorelement - m unterschiedliche Filterübertragungskurven realisieren können. Dabei kann jeder der m Resonatoren genau einer Filterübertragungskurve zugeordnet sein. Es ist aber auch möglich, dass einer Filterübertragungskurve mehrere gleichzeitig aktive Resonatorelemente zugeordnet sind. So ermöglichen m Resonatorelemente bis zu m! (Fakultät von m) unterschiedliche Filterübertragungskurven. m kann dabei 2, 3, 4, 5, 6, 7, 8, 9, 10 oder noch mehr betragen. Sind die Resonatorelemente parallel geschaltet, sind $2^m$ unterschiedliche Filterübertragungskurven möglich.

Die Schalter können dabei in Halbleiterbauweise erstellte Schalter wie CMOS-Schalter (CMOS = Complementary metal-oxidesemiconductor), auf GaAs (Galliumarsenid) basierende Schalter oder JFET-Schalter (JFET = Junction-Fet [FET = Feldeffekttransistor]) sein. MEMS-Schalter (MEMS = Microelectromechanical System) sind auch möglich und stellen exzellente lineare Eigenschaften zur Verfügung.

Es ist deshalb möglich, dass alle Resonatoren auf verschiedene Frequenzbänder abstimmbar sind.

Es ist insbesondere möglich, dass die Abstimmbarkeit der Resonatoren eine Kompensation einer Temperaturschwankung, eine Justierung des Filters hinsichtlich einer Impedanzanpassung, eine Justierung des Filters hinsichtlich einer Einfügedämpfung oder eine Justierung des Filters hinsichtlich einer Isolation ermöglicht.

Es ist ferner möglich, dass jeder Resonator gleichviele Resonatorelemente umfasst, die über Schalter, die über eine MIPI-Schnittstelle (MIPI = Mobile Industry Processor Interface) ansprechbar sind, steuerbar sind.

Es ist möglich, dass ein oder mehrere Impedanzwandler passive Impedanzelemente umfasst oder daraus bestehen. Der Impedanzwandler kann deshalb zwei parallele kapazitive Elemente und ein paralleles induktives Element umfassen. Dabei sind Querzweige, z. B. gegen Masse, gemeint, die ein entsprechendes kapazitives bzw. induktives Element enthalten.

Es ist auch möglich, dass ein Impedanzwandler drei parallele kapazitive Elemente umfasst.

Es ist auch möglich, dass ein Impedanzwandler drei parallele induktive Elemente umfasst.

Es ist auch möglich, dass ein Impedanzwandler zwei parallele induktive Elemente und ein paralleles kapazitives Element umfasst.

Rechnerisch kann es sich ergeben, dass einzelne Impedanzelemente negative Impedanzwerte, z.B. negative Induktivitäten oder negative Kapazitäten, aufzuweisen haben. Negative Impedanzwerte sind aber zumindest dann unproblematisch, wenn die entsprechenden Impedanzelemente mit anderen Impedanzelementen des HF-Filters zu verschalten sind, so dass die Verschaltung mit den anderen Elementen in der Summe wieder positive Impedanzwerte hat. In diesem Fall würde die Verschaltung der eigentlich vorgesehenen Elemente durch das Element mit positivem Impedanzwert ersetzt.

Es ist ferner möglich, dass das HF-Filter zwei in Serie verschaltete Grundglieder und ein kapazitives Element, das parallel zu den zwei in Serie verschalteten Grundgliedern verschaltet ist, umfasst.

Es ist möglich, dass das HF-Filter einen Signalpfad, vier kapazitive Elemente im Signalpfad, sechs schaltbare Resonatoren mit jeweils einem Resonatorelement und einem dazu in Serie in einem Querzweig gegen Masse verschalteten Schalter, sowie ein induktives Element, das parallel zu zwei der vier kapazitiven Elemente geschaltet ist, umfasst.

Nachfolgend werden wichtige Prinzipien erläutert und eine nicht abschließende Aufzählung von beispielhaften und schematischen Schaltungen verdeutlichen zentrale Aspekte des HF-Filters.

Es zeigen:

Fig. 1: ein HF-Filter F mit drei Resonatoren und vier Impedanzwandlern,

Fig. 2: ein Filter mit drei Resonatoren und zwei Impedanzwandlern,

Fig. 3: einen erfindungsgemäßen Duplexer D mit einem Sendefilter TX und einem Empfangsfilter RX, die über eine Impedanzanpassschaltung mit einer Antenne verschaltet sind,

Fig. 4: ein HF-Filter F, bei dem mittig ein Serienresonator S und peripher jeweils ein Serienresonator mit zwei Impedanzwandlern verschaltet sind,

Fig. 5: ein HF-Filter F, das ausschließlich Parallelresonatoren als verwendete Resonatoren umfasst,

Fig. 6: ein HF-Filter F, bei dem ein Impedanzwandler einen ersten Resonator direkt mit einem dritten Resonator verschaltet,

Fig. 7: ein HF-Filter F, bei dem ein Admittanz-Inverter einen ersten Resonator mit einem dritten Resonator direkt verschaltet,

Fig. 8: ein HF-Filter mit abstimmbaren Resonatoren,

Fig. 9A bis Fig. 9K: verschiedene Ausführungsformen abstimmbarer Resonatoren,

Fig. 10A: einen abstimmbaren Resonator mit per Schalter aktivierbaren Serienresonatorelementen,

Fig. 10B: einen abstimmbaren Resonator mit mittels Schalter aktivierbaren Parallelresonatoren,

Fig. 11A bis Fig. 11F: verschiedene Ausführungsformen eines Impedanz-Inverters,

Fig. 12A bis Fig. 12F: verschiedene Ausführungsformen eines Admittanz-Inverters,

Fig. 13A bis Fig. 13C: verschiedene Abstraktionsstufen beim Entwurf eines HF-Filters,

Fig. 14A bis Fig. 14H: verschiedene konkrete Ausführungsformen eines HF-Filters mit zwei abstimmbaren Serienresonatoren und drei Impedanzwandlern,

Fig. 15A bis Fig. 15H: Ausgestaltungen eines HF-Filters mit zwei abstimmbaren Resonatoren, drei Impedanzwandlern und jeweils einem überbrückenden kapazitiven Element,

Fig. 16: die Einfügedämpfung eines Resonators (A) und eines entsprechenden Bandpassfilters (B),

Fig. 17: die Durchlasskurven des HF-Filters aus Fig. 16, wobei abstimmbare Impedanzelemente in ihrer Impedanz verändert sind, um eine neue Lage des Durchlassbereichs B zu erhalten,

Fig. 18: die Admittanz (A) eines Resonators und die Einfügedämpfung (B) eines entsprechenden Bandpassfilters mit Admittanz-Invertern,

Fig. 19: das HF-Filter zur Fig. 18, wobei Impedanzwerte abstimmbarer Impedanzelemente variiert wurden, um eine veränderte Lage des Durchlassbereichs zu erhalten,

Fig. 20: Einfügedämpfungen (B, B') eines HF-Filters, bei dem durch Abstimmen von Resonatoren unterschiedliche Frequenzlagen des Durchlassbereichs erhalten werden,

Fig. 21: unterschiedliche Durchlasskurven (B, B') eines HF-Filters mit Parallelresonatoren und Admittanz-Invertern, bei denen unterschiedliche Impedanzwerte unterschiedliche Lagen des Durchlassbereichs bewirken,

Fig. 22: Einfügedämpfungen eines abstimmbaren Duplexers: Die Kurven B1 und B3 bezeichnen dabei ein abstimmbares Sendefrequenzband. Die Kurven B2 und B4 stellen die Einfügedämpfungen eines einstellbaren Empfangsfrequenzbands,

Fig. 23: eine mögliche Filterschaltung,

Fig. 24: eine mögliche Form der Integration von Schaltungskomponenten in einem Bauteil,

Fig. 25: Übertragungsfunktionen eines abstimmbaren Filters nach Fig. 23.

Figur 1 zeigt eine HF-Filterschaltung F mit drei Resonatoren und vier Impedanzwandlern IW. Der mittlere Resonator stellt dabei ein Grundglied GG dar. Der mittlere Resonator kann ein Parallelresonator P oder ein Serienresonator S sein. Die beiden Impedanzwandler IW, die den ersten Resonator umgeben, bewirken, dass der Resonator nach außen hin wie ein Serienresonator oder wie ein Parallelresonator aussieht. Ist der mittlere Resonator ein Parallelresonator, so kann auch der erste Resonator ein Parallelresonator sein, der nach außen wie ein Serienresonator aussieht. Entsprechend wäre dann auch der dritte Resonator ein Parallelresonator, der nach außen hin wie ein Serienresonator aussieht. Umgekehrt kann der mittlere Resonator ein Serienresonator S sein. Dann wären auch die beiden äußeren Resonatoren Serienresonatoren, die nach außen hin wie Parallelresonatoren aussehen. So kann unter Verwendung der Impedanzwandler IW eine Ladder-type ähnliche Filterstruktur erhalten werden, obwohl ausschließlich Serienresonatoren oder obwohl ausschließlich Parallelresonatoren verwendet werden.

Figur 2 zeigt eine Filterschaltung, bei der der mittlere Resonator durch die ihn umgebenden Impedanzwandler IW so maskiert wird, dass das Filter nach außen hin wie eine alternierende Abfolge von Parallel- und Serienresonatoren aussieht, obwohl lediglich ein Typ eines Resonators verwendet wird.

Figur 3 zeigt einen erfindungsgemäßen Duplexer D, bei dem sowohl das Sendefilter TX als auch das Empfangsfilter RX Serienverschaltungen aus Impedanzwandlern und Resonatoren umfassen, die so miteinander verschaltet sind, dass pro Filter lediglich ein Typ von Resonatoren notwendig ist. Da Serienresonatoren geeignet sind, eine steile rechte Filterflanke eines Passbands zu bilden und da Sendefrequenzbänder im Allgemeinen frequenzmäßig unterhalb der Empfangsfrequenzbänder liegen, ist es vorteilhaft, im Sendefilter TX Serienresonatoren zu verwenden. Analog wären im Empfangsfilter RX Parallelresonatoren zu verwenden. Liegt das Sendefrequenzband oberhalb des Empfangsfrequenzbandes, so wären entsprechend Serienresonatoren im Empfangsfilter und Parallelresonatoren im Sendefilter vorteilhaft.

Die Filter TX, RX sind über eine Impedanzanpassschaltung IAS mit einer Antenne ANT verschaltet. Aus Sicht der Impedanzanpassschaltung IAS sieht jedes der beiden Filter TX, RX aus wie eine konventionelle Ladder-type Filterschaltung, sodass praktisch kein zusätzlicher Aufwand beim Entwerfen der übrigen Schaltungskomponenten wie Antenne und Impedanzanpassschaltung notwendig ist.

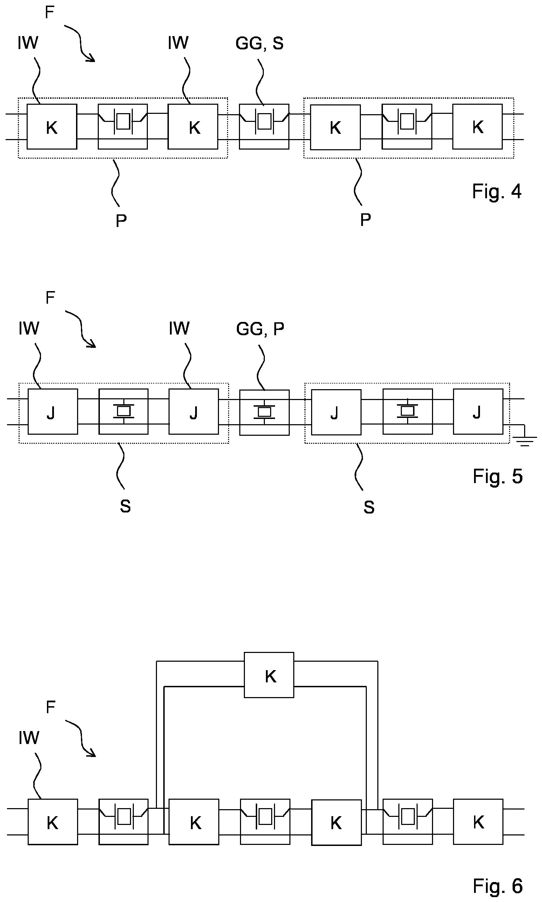

Figur 4 zeigt entsprechend eine Ausführungsform, bei der der mittlere Resonator als Serienresonator S ausgeführt ist. Durch die Wirkung der Impedanzwandler IW kann auch in den beiden äußeren Resonatoren jeweils ein serielles Resonatorelement Verwendung finden, obwohl die Kombination aus Impedanzwandlern und Serienresonator nach außen hin wie ein Parallelresonator P aussieht und in Erscheinung tritt. Um Serienresonatoren nach außen hin wie Parallelresonatoren erscheinen zu lassen, werden bevorzugt Impedanz-Inverter K eingesetzt.

Im Gegensatz dazu zeigt Figur 5 eine Ausführungsform eines HF-Filters F, bei dem ausschließlich Parallelresonatoren Verwendung finden. Unter der Verwendung von Admittanz-Invertern J als Ausführungsformen der Impedanzwandler IW erscheinen die beiden äußeren Parallelresonatoren als Serienresonatoren S. Zusammen mit dem zentralen, mittleren Resonator, einem Parallelresonator P, bildet das HF-Filter F eine Quasi-Ladder-type Struktur.

Figur 6 zeigt eine Ausführungsform, bei der die beiden äußeren Resonatoren direkt über einen weiteren Impedanzwandler, z. B. einen Impedanz-Inverter, verschaltet sind. Die direkte Verschaltung der äußeren Resonatoren über einen weiteren Impedanzwandler stellt einen neuen Freiheitsgrad dar, über den ein HF-Filter weiter optimiert werden kann.

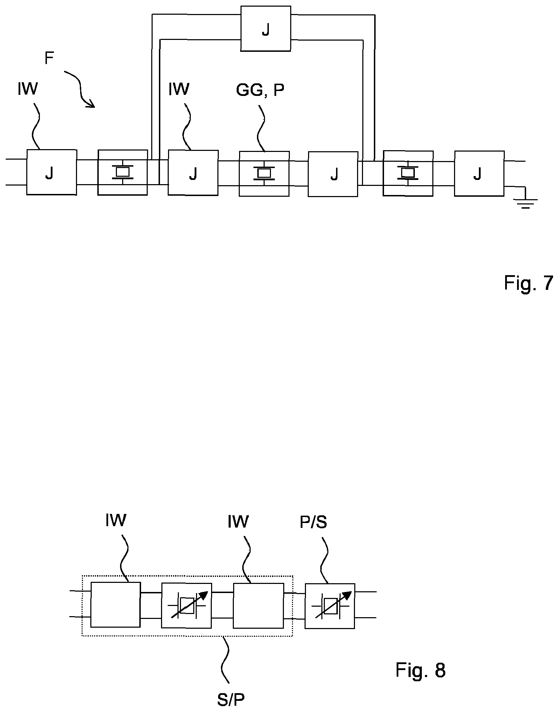

Figur 7 zeigt beispielhaft eine Ausführungsform eines HF-Filters F, welches Parallelresonatoren und Admittanz-Inverter J verwendet. Dabei sind auch die beiden äußeren Resonatoren direkt über einen weiteren Admittanz-Inverter J miteinander verschaltet.

Figur 8 zeigt eine mögliche Ausführungsform eines HF-Filters, bei dem die Resonatoren abstimmbar sind.

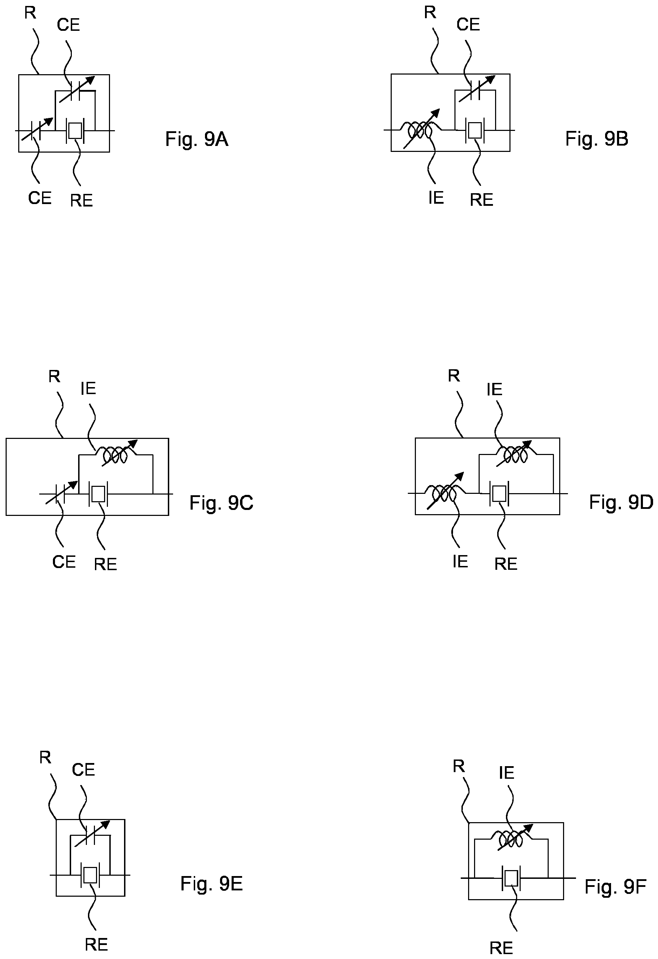

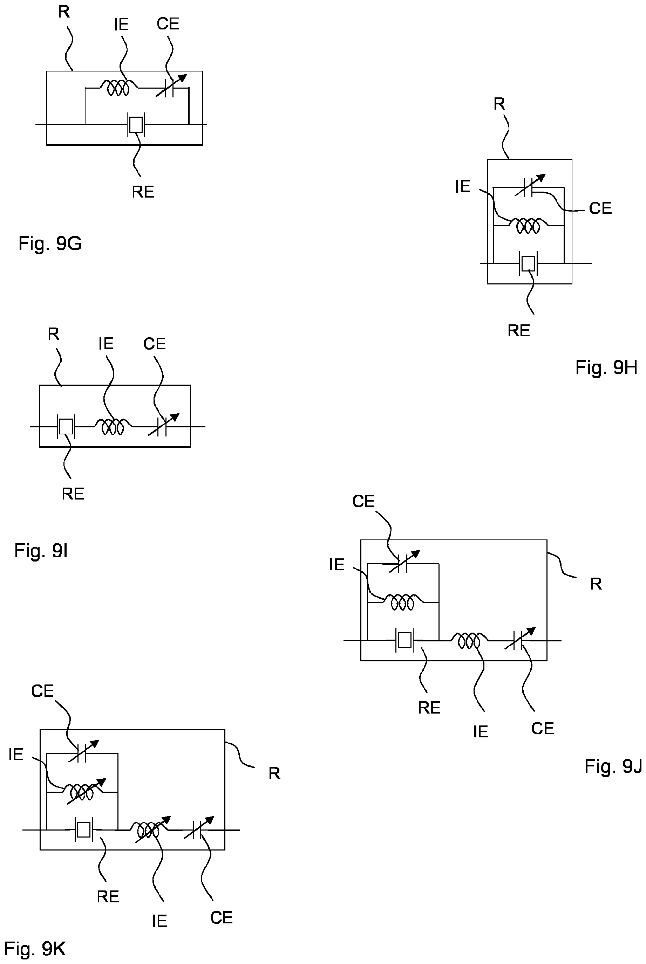

Figur 9 zeigt eine mögliche Ausführungsform eines abstimmbaren Resonators R. Der Resonator R umfasst ein Resonatorelement RE. Das Resonatorelement RE kann dabei ein mit akustischen Wellen arbeitendes Resonatorelement sein. Parallel zum Resonatorelement RE ist ein kapazitives Element CE verschaltet. In Serie zur Parallelverschaltung ist ein weiteres kapazitives Element CE verschaltet. Die beiden kapazitiven Elemente CE sind abstimmbar, d. h. ihre Kapazität kann eingestellt werden. Je nach verwendeten kapazitiven Elementen kann die Kapazität kontinuierlich oder in diskreten Werten eingestellt werden. Umfassen die kapazitiven Elemente beispielsweise Varaktoren, so kann durch Anlegen einer Bias-Spannung die Kapazität kontinuierlich eingestellt werden. Umfasst ein kapazitives Element CE eine Bank von kapazitiven Einzelelementen, die mittels eines oder mehrerer Schalter individuell angesteuert werden können, so kann die Kapazität des entsprechenden kapazitiven Elements CE in diskreten Schritten eingestellt werden.

Figur 9B zeigt eine alternative Möglichkeit eines Resonators R, bei dem die Serienverschaltung eines abstimmbaren kapazitiven Elements CE mit einem Resonatorelement RE in Serie mit einem abstimmbaren induktiven Element IE verschaltet ist.

Figur 9C zeigt eine mögliche Ausführungsform eines abstimmbaren Resonators R, bei dem ein Resonatorelement RE parallel zu einem abstimmbaren induktiven Element IE verschaltet ist. Diese Parallelschaltung ist in Serie mit einem abstimmbaren kapazitiven Element CE verschaltet.

Figur 9D zeigt eine weitere alternative Ausführungsform für einen abstimmbaren Resonator R. Dabei ist - im Vergleich zu Figur 9C - die Parallelschaltung mit einem abstimmbaren induktiven Element IE in Serie verschaltet.

Figur 9E zeigt eine weitere alternative Ausführungsform eines abstimmbaren Resonators, bei dem ein Resonatorelement RE lediglich parallel mit einem abstimmbaren kapazitiven Element CE verschaltet ist.

Figur 9F zeigt eine weitere alternative Ausführungsform eines abstimmbaren Resonators R. Dabei ist ein Resonatorelement RE parallel zu einem abstimmbaren induktiven Element IE verschaltet.

Figuren 9E und 9F zeigen relativ einfache Ausführungsformen eines abstimmbaren Resonators R. Die Figuren 9A bis 9D zeigen Ausführungsformen eines abstimmbaren Resonators R, die durch ein weiteres abstimmbares Element weitere Freiheitsgrade beim Abstimmen ermöglichen. Insofern können die gezeigten Ausführungsformen mit weiteren kapazitiven und induktiven Elementen mit fester Impedanz oder variierbarer Impedanz in Serie oder parallel verschaltet werden, um zusätzliche Freiheitsgrade, z. B. für einen breiteren Abstimmbereich, zu erhalten.

Figur 9G zeigt eine Ausführungsform eines abstimmbaren Resonators R, bei dem das Resonatorelement RE parallel zu einer Serienverschaltung, umfassend ein induktives Element IE und ein abstimmbares kapazitives Element CE, verschaltet ist.

Figur 9H zeigt eine Ausführungsform eines abstimmbaren Resonators R, bei dem das Resonatorelement RE parallel zu einer Parallelverschaltung, umfassend ein induktives Element IE und ein abstimmbares kapazitives Element CE, verschaltet ist.

Figur 9I zeigt eine Ausführungsform eines abstimmbaren Resonators R, bei dem das Resonatorelement RE in Serie zu einer Serienverschaltung, umfassend ein induktives Element IE und ein abstimmbares kapazitives Element CE, verschaltet ist.

Figur 9J zeigt eine Ausführungsform eines abstimmbaren Resonators R, bei dem das Resonatorelement RE einerseits in Serie zu einer Serienverschaltung, umfassend ein induktives Element IE und ein abstimmbares kapazitives Element CE, verschaltet und andererseits parallel zu einer Parallelverschaltung, umfassend ein induktives Element IE und ein abstimmbares kapazitives Element CE, verschaltet ist.

Figur 9K zeigt eine Ausführungsform eines abstimmbaren Resonators R, bei dem das Resonatorelement RE einerseits in Serie zu einer Serienverschaltung, umfassend ein abstimmbares induktives Element IE und ein abstimmbares kapazitives Element CE, verschaltet und andererseits parallel zu einer Parallelverschaltung, umfassend ein abstimmbares induktives Element IE und ein abstimmbares kapazitives Element CE, verschaltet ist.

Ferner gilt, dass neben kontinuierlich abstimmbaren Elementen wie Varaktoren und schaltbaren Elementen konstanter Impedanz auch schaltbare abstimmbare Elemente, z. B. mittels Schalter hinzu-schaltbare Varaktoren möglich sind.

Noch allgemeiner gilt, dass in einem Resonator das Resonatorelement in Serie mit einem Seriennetzwerk und parallel mit einem Parallelnetzwerk verschaltet sein kann. Das Seriennetzwerk und das Parallelnetzwerk können dabei jeweils Impedanzelemente fester oder variabler Impedanz umfassen.

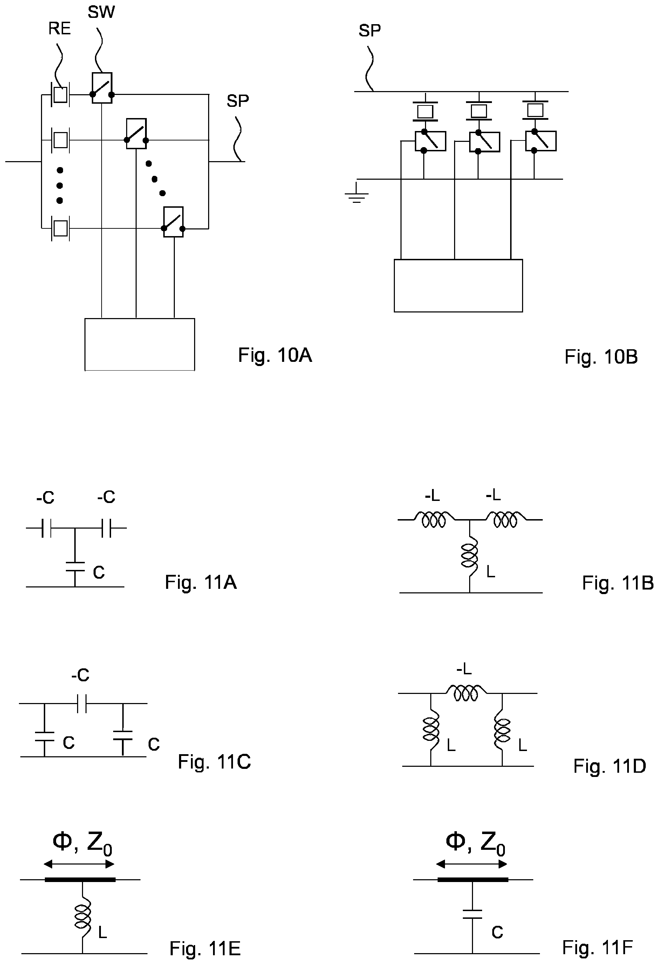

Figur 10 zeigt eine zusätzliche mögliche Ausführungsform eines abstimmbaren Resonators R, welcher eine Vielzahl an Resonatorelementen RE und eine Vielzahl von Schaltern SW umfasst. Figur 10A zeigt dabei Resonatorelemente RE, die in Serie im Signalpfad SP verschaltet sind. Damit ist ein abstimmbarer Serienresonator dargestellt. Durch individuelles Öffnen und Schließen der einzelnen Schalter SW können individuell einstellbar bestimmte Resonatorelemente RE in den Signalpfad SP eingekoppelt werden. Umfasst der abstimmbare Resonator R in Figur 10A m Resonatorelemente RE, so können $2^m$ unterschiedliche Schaltzustände erhalten werden.

Figur 10B zeigt eine Ausführungsform eines abstimmbaren Resonators R, bei dem Resonatorelemente den Signalpfad SP mit Masse verschalten. Da die Reihenfolge der einzelnen Resonatorelemente RE, in der sie mit dem Signalpfad SP verschaltet sind, prinzipiell relevant ist, können m! (Fakultät) unterschiedliche Resonatorzustände erhalten werden.

Die Figuren 11A bis 11F geben verschiedene Ausführungsformen eines Impedanz-Inverters an.

Figur 11A zeigt somit eine Form eines Impedanzwandlers, welche einen Impedanz-Inverter darstellt. Zwei kapazitive Elemente sind in Serie im Signalpfad verschaltet. Ein kapazitives Element verschaltet den gemeinsamen Schaltungsknoten der beiden kapazitiven Elemente im Signalpfad mit Masse. Die kapazitiven Elemente im Signalpfad erhalten rechnerisch eine negative Kapazität -C. Das kapazitive Element im Parallelpfad gegen Masse erhält rechnerisch eine positive Kapazität C.

Wie oben schon beschrieben, ergeben sich die Kapazitätswerte lediglich aus den Berechnungsvorschriften für zwei Tore. Die in Figur 11A gezeigte T-Schaltung braucht deshalb keinesfalls so in einer Schaltungsumgebung realisiert sein. Vielmehr können die kapazitiven Elemente mit negativer Kapazität im Serienpfad mit weiteren kapazitiven Elementen positiver Kapazität, die im Serienpfad zusätzlich verschaltet sind, kombiniert werden, sodass insgesamt jeweils eines oder mehrere kapazitive Elemente positiver Kapazität erhalten werden.

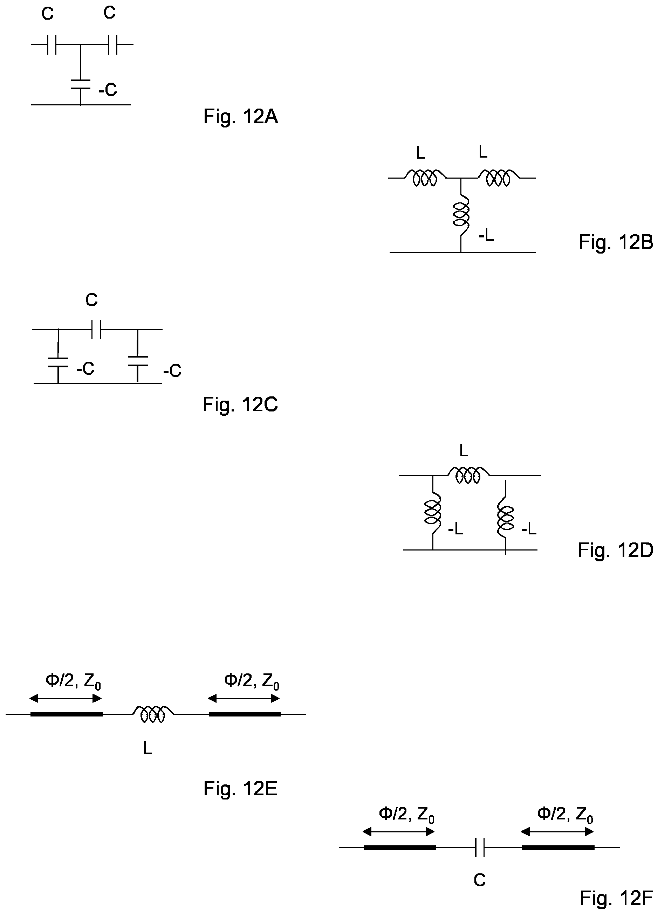

Das Gleiche gilt für die Ausführungsformen der Figuren 11B, 11C und 11D sowie für die Ausführungsformen der Admittanz-Inverter in den Figuren 12A, 12B, 12C und 12D.

Figur 11B zeigt eine T-Schaltung aus induktiven Elementen, wobei die beiden induktiven Elemente, die im Signalpfad in Serie geschaltet sind, rein formal eine negative Induktivität aufzuweisen haben.

Figur 11C zeigt eine Form eines Impedanz-Inverters, der als Pi-Schaltung mit einem kapazitiven Element negativer Kapazität im Serienpfad und zwei kapazitiven Elementen positiver Kapazität in jeweils einem Parallelpfad aufweist.

Figur 11D zeigt eine Ausführungsform eines Impedanz-Inverters in Pi-Form, bei der die Induktivität des induktiven Elements im Signalpfad negativ ist. Die Induktivitäten der induktiven Elemente in den entsprechenden beiden Parallelpfaden sind positiv.

Figur 11E zeigt eine Ausführungsform eines Impedanz-Inverters mit einer Phasenschieberschaltung und einem induktiven Element der Induktivität L. Die Phasenschieberschaltung hat dabei vorzugsweise die charakteristische Impedanz der Signalleitung $Z_0$. Der Phasenversatz $\Theta$ durch die PhasenschieberSchaltung ist geeignet eingestellt.

So kann $\Theta$ im Fall eines Impedanz-Inverters z. B. durch die Gleichung $\Theta = -tan^{-1} \frac{2X}{Z_0}$ bestimmt sein.

Dabei ist $X = \frac{K}{1-\left(\frac{k}{Z_0}\right)^2}$ und K durch $Z_{in} = \frac{K^2}{Z_l}$ bestimmt. Im Fall eines Admittanz-Inverters kann gelten:

$\Theta = -tan^{-1} \frac{2B}{Y_0}$. Dabei ist $B = \frac{J}{1-\left(\frac{J}{Y_0}\right)^2}$ und J durch $Y_{in} = \frac{J^2}{Z_l}$ bestimmt.

Analog zu Figur 11E zeigt Figur 11F eine alternative Ausführungsform, bei der das induktive Element durch ein kapazitives Element der Kapazität C ersetzt ist.

Die Figuren 12A bis 12F zeigen Ausführungsformen eines Admittanz-Inverters.

Figur 12A zeigt eine Ausführungsform eines Admittanz-Inverters in T-Konfiguration, bei dem die beiden kapazitiven Elemente im Serienpfad positive Kapazitäten aufweisen. Das kapazitive Element im Parallelpfad weist nominell eine negative Kapazität auf.

Figur 12B zeigt eine Ausführungsform eines Admittanz-Inverters in T-Konfiguration, wobei im Signalpfad zwei induktive Elemente der Induktivität L in Serie verschaltet sind. In einem Parallelpfad, der zwei Elektroden der induktiven Elemente mit Masse verschaltet, ist ein induktives Element mit der negativen Induktivität -L verschaltet.

Figur 12C zeigt eine Ausführungsform eines Admittanz-Inverters in Pi-Konfiguration, wobei die beiden kapazitiven Elemente in den beiden Parallelpfaden eine negative Kapazität aufweisen. Das kapazitive Element im Signalpfad weist eine positive Kapazität auf.

Figur 12D zeigt eine Ausführungsform eines Admittanz-Inverters in Pi-Konfiguration mit drei induktiven Elementen. Das induktive Element im Serienpfad weist eine positive Induktivität auf. Die beiden induktiven Elemente in den beiden Parallelpfaden weisen jeweils eine negative Induktivität auf.

Figur 12E zeigt eine Ausführungsform eines Admittanz-Inverters, bei dem ein induktives Element mit positiver Induktivität L zwischen zwei Segmenten einer Phasenschieberschaltung verschaltet ist. Jedes Segment der Phasenschieberschaltung hat eine charakteristische Impedanz $Z_0$ und verschiebt die Phase geeignet.

Entsprechend der Figur 12E zeigt Figur 12F eine Ausführungsform eines Admittanz-Inverters, der ebenfalls auf Phasenschieberschaltungen beruht. Zwischen zwei Segmenten einer Phasenschieberschaltung ist ein kapazitives Element mit positiver Kapazität C verschaltet.

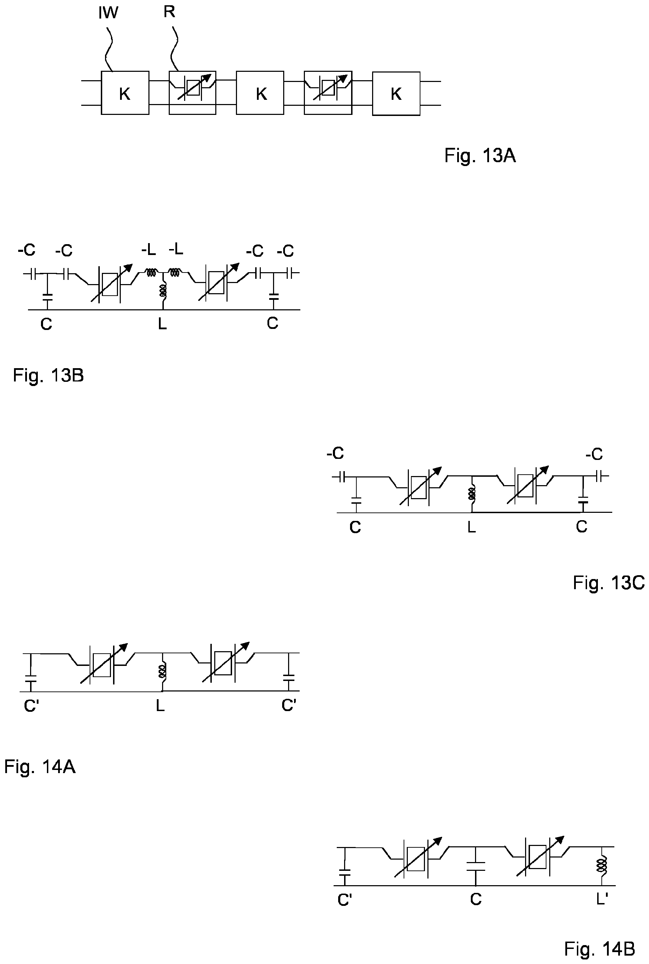

Figur 13 zeigt die Verwendung von abstimmbaren Resonatoren R zusammen mit Impedanzwandlern IW. Der Resonator kann dabei ein Serienresonator sein. Durch die Verwendung von Impedanz-Invertern K als Impedanzwandler IW ergibt eine Kombination aus zwei Impedanzwandlern IW und einem dazwischen verschalteten Serienresonator insgesamt ein Parallelresonator.

Ersetzt man die Impedanzwandler IW der Figur 13A durch Impedanz-Inverter, wie sie beispielsweise aus den Figuren 11A bis 11F, z. B. 11A, bekannt sind, so wird die Schaltungsstruktur der Figur 13B erhalten. Problematisch scheinen die Kapazitätselemente mit negativer Kapazität. Berücksichtigt man jedoch, dass die Resonatoren R selbst Eigenschaften kapazitiver Elemente positiver Kapazität haben, so entfällt der Bedarf an kapazitiven Elementen mit negativer Kapazität, die direkt mit den Resonatorelementen verschaltet sind. Dies ist in Figur 13C gezeigt.

Berücksichtigt man ferner kapazitive Elemente, die in der Schaltungsumgebung des HF-Filters verschaltet sind, so entfällt auch der Bedarf an den peripheren kapazitiven Elementen negativer Kapazität der Figur 13C. Insgesamt wird dann eine Schaltungsstruktur, wie in 14A gezeigt, erhalten. Auch wenn eine externe Schaltungsumgebung des HF-Filters keine Möglichkeit zur Kompensation der negativen Kapazitäten -C in Figur 13 zur Verfügung stellt, so kann die negative Kapazität durch die positive Kapazität des kapazitiven Elements im Parallelpfad kompensiert werden.

Figur 14A zeigt somit eine einfach herzustellende HF-Filterschaltung mit zwei abstimmbaren Resonatoren und drei Impedanzelementen, deren Impedanz so gewählt ist, dass einer der beiden Resonatoren als Parallelresonator wirkt. Figur 14A zeigt deshalb im Wesentlichen ein Grundglied einer Ladder-type Filterschaltung, obwohl lediglich Serienresonatoren verwendet werden.

Figur 14B zeigt eine Alternative zum HF-Filter der Figur 14A, denn das induktive Element L zwischen den Resonatoren ist durch ein kapazitives Element C und das kapazitive Element im lastseitigen Parallelpfad ist durch ein induktives Element ersetzt.

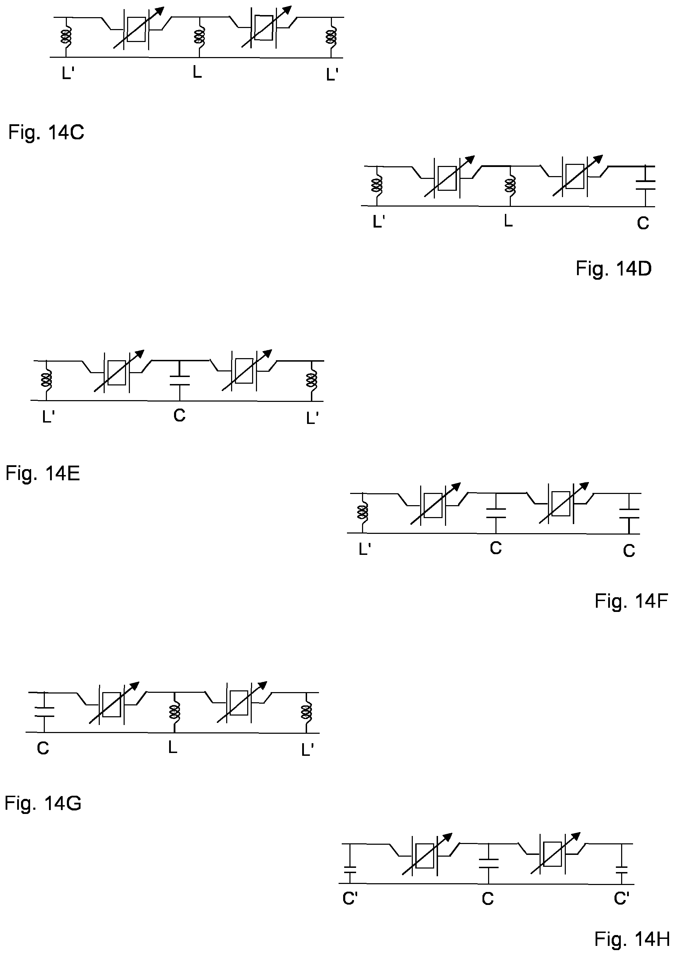

Figur 14C zeigt eine weitere Ausführungsform eines HF-Filters mit zwei Resonatoren, wobei drei induktive Elemente in jeweils einem Parallelpfad verschaltet sind.

Figur 14D zeigt eine mögliche Ausführungsform eines HF-Filters, bei dem die linken beiden Impedanzelemente durch induktive Elemente und das rechte Impedanzelement durch ein kapazitives Element gebildet sind.

Figur 14E zeigt eine Ausführungsform, bei der die äußeren beiden Impedanzelemente durch induktive Elemente und das zentrale Impedanzelement durch ein kapazitives Element gebildet sind.

Figur 14F zeigt eine Ausführungsform, bei der die rechten beiden Impedanzelemente durch kapazitive Elemente und das linke Impedanzelement durch ein induktives Element gebildet sind.

Figur 14G zeigt eine Ausführungsform, bei der die rechten beiden Impedanzelemente durch induktive Elemente und das linke Impedanzelement durch ein kapazitives Element gebildet sind.

Figur 14H zeigt eine Ausführungsform, bei der alle drei Impedanzelemente durch kapazitive Elemente gebildet sind.

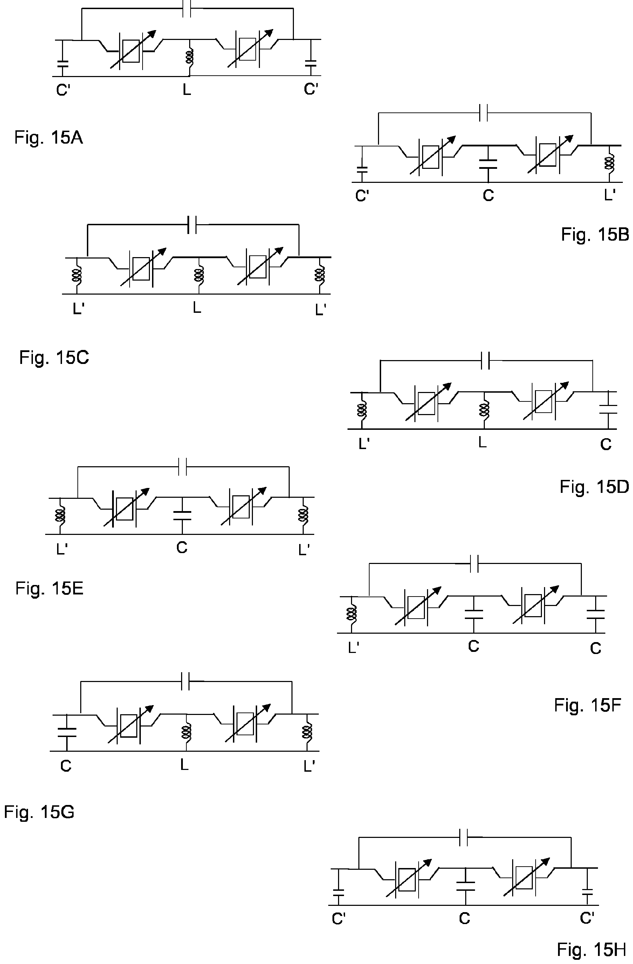

Die Figuren 15A bis 15H zeigen weitere Alternativen der HF-Filter der Figuren 14A bis 14H, wobei ein weiteres Impedanzelement den Signaleingang und den Signalausgang direkt miteinander verschaltet. Alternativ zum überbrückenden kapazitiven Element kann ein überbrückendes induktives Element oder andere Ausführungsformen von Impedanzwandlern verwendet werden.

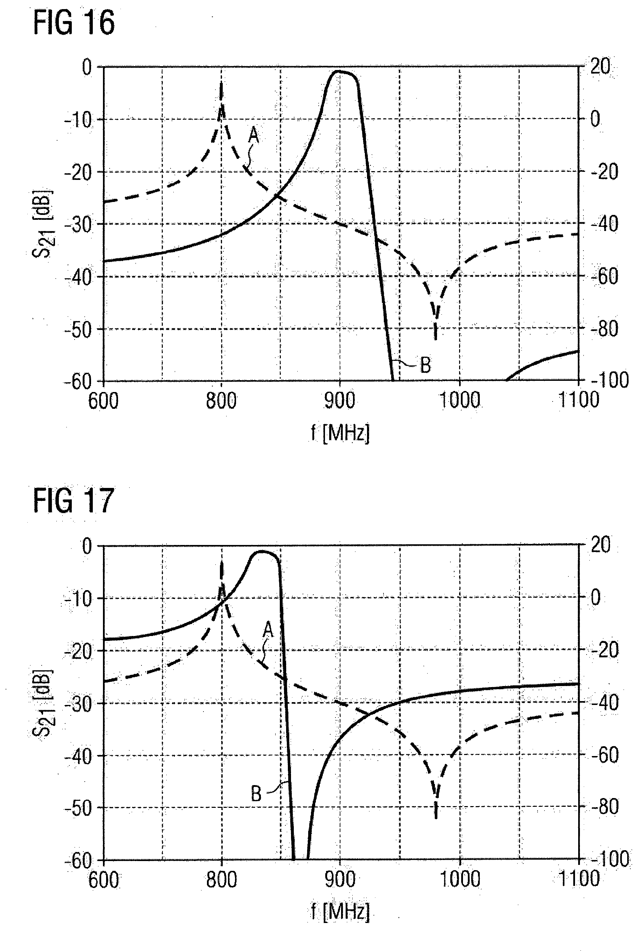

Figur 16 zeigt die Admittanz eines Resonators (Kurve A) und die Übertragungsfunktion eines HF-Filters mit einem solchen Resonator (Kurve B). Serielle kapazitive Elemente haben einen Wert von 2,4 pF. Parallele kapazitive Elemente haben einen Wert von 0,19 pF.

Figur 17 zeigt die entsprechenden Kurven, wobei serielle abstimmbare Kapazitäten auf einen Kapazitätswert von 30 pF und parallele abstimmbare Kapazitäten auf einen Kapazitätswert von 3,7 pF eingestellt worden sind. Die Impedanzwandler der den Figuren 16 und 17 zugehörigen Filter sind Impedanz-Inverter. Die Resonatoren sind Serienresonatoren.

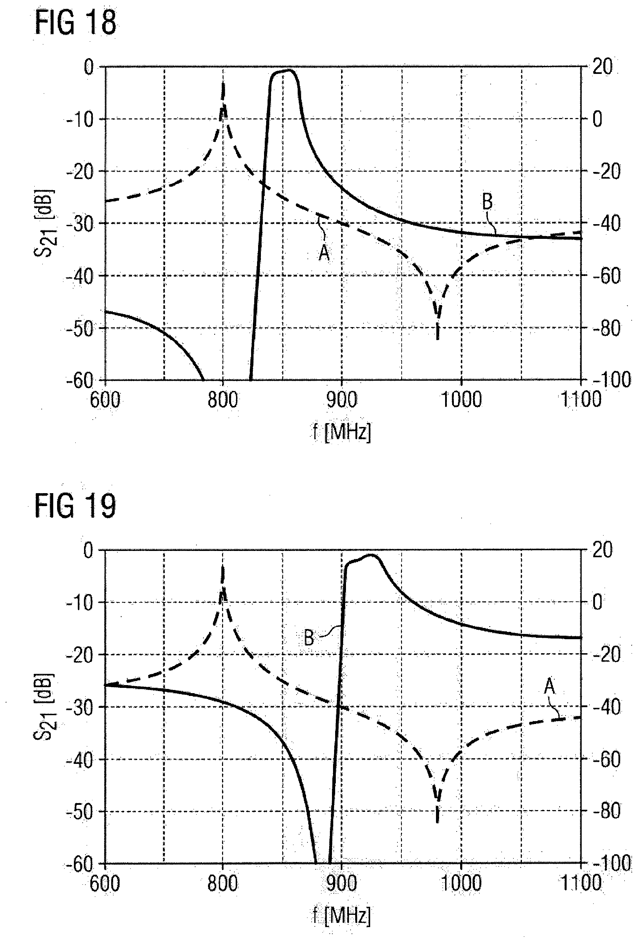

Im Vergleich dazu zeigen die Figuren 18 und 19 entsprechende Kurven von HF-Filtern mit Admittanz-Invertern und parallelen Resonatoren. Figur 18 zeigt dabei die charakteristischen Kurven eines Filters, bei dem serielle abstimmbare Kapazitäten einen Wert von 2,4 pF und parallele abstimmbare kapazitive Elemente einen Wert von 0,19 pF aufweisen.

Figur 19 zeigt die entsprechenden Kurven des HF-Filters, bei dem die seriellen abstimmbaren Kapazitäten einen Wert von 30 pF und die parallelen abstimmbaren Kapazitäten einen Wert von 3,7 pF aufweisen.

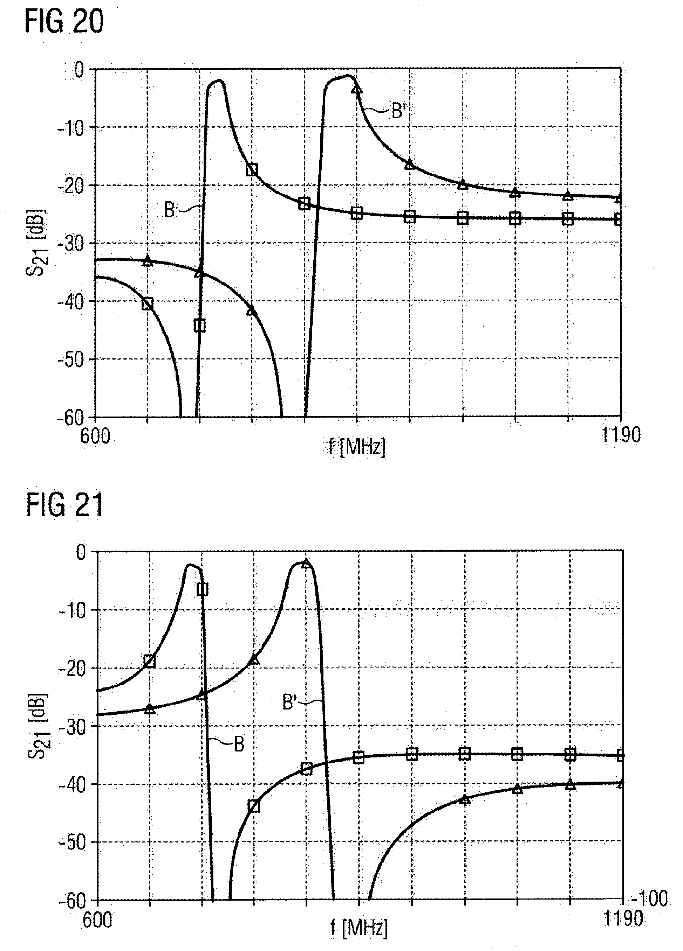

Figur 20 zeigt Einfügedämpfungen von Bandpassfiltern mit Admittanz-Invertern und Parallelresonatoren. Das Filter weist abstimmbare Resonatoren auf, die durch einstellbare Kapazitäten kapazitiver Elemente einmal auf das Empfangsband 17 bzw. Band 5 abgestimmt sind. Die Resonatoren umfassen dabei mittels Schalter koppelbare Resonatorelemente wie in Fig. 10B gezeigt.

Figur 21 zeigt dabei Durchlasskurven eines HF-Filters mit Impedanz-Invertern und Serienresonatoren, wobei die abstimmbaren Werte einmal auf die Sendefrequenzen des Bands 17 und einmal auf die Sendefrequenzen des Bands 5 abgestimmt sind. Die Resonatoren umfassen dabei mittels Schalter koppelbare Resonatorelemente wie in Fig. 10A gezeigt.

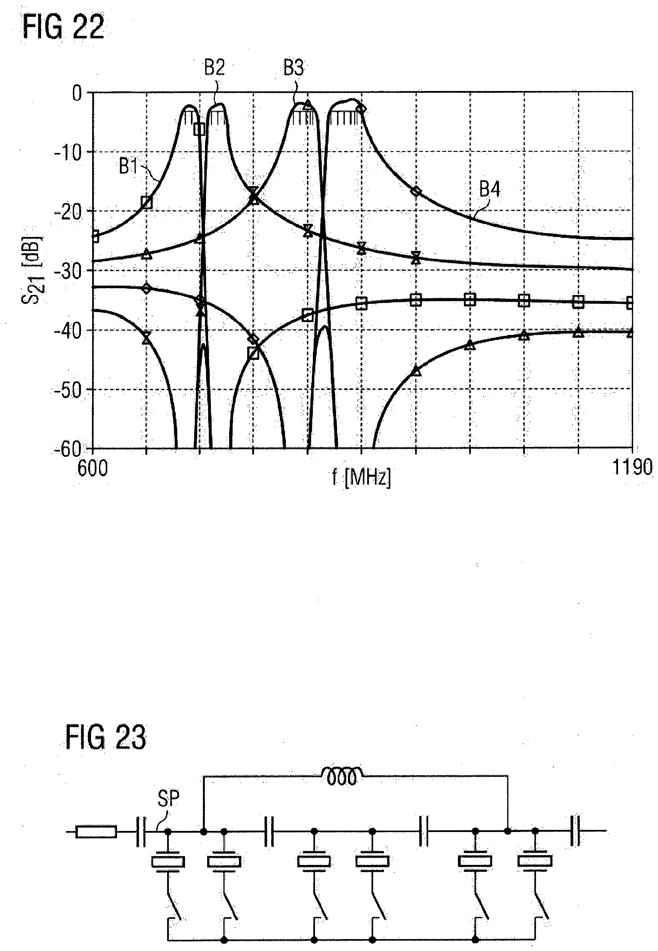

Figur 22 zeigt die Einfügedämpfungen der Empfangs- bzw. Sendefilter eines abstimmbaren Duplexers, einmal auf Band 17 und einmal auf Band 15 abgestimmt.

Fig. 23 zeigt eine mögliche Ausführungsform des HF-Filters. Im Signalpfad SP sind vier kapazitive Elemente in Serie verschaltet. In sechs Querzweigen gegen Masse ist je ein schaltbarer Resonator verschaltet. Jeder der schaltbaren Resonatoren umfasst ein Resonatorelement und einen dazu in Serie verschalteten Schalter. Ein induktives Element ist parallel zu zwei der vier kapazitiven Elemente geschaltet.

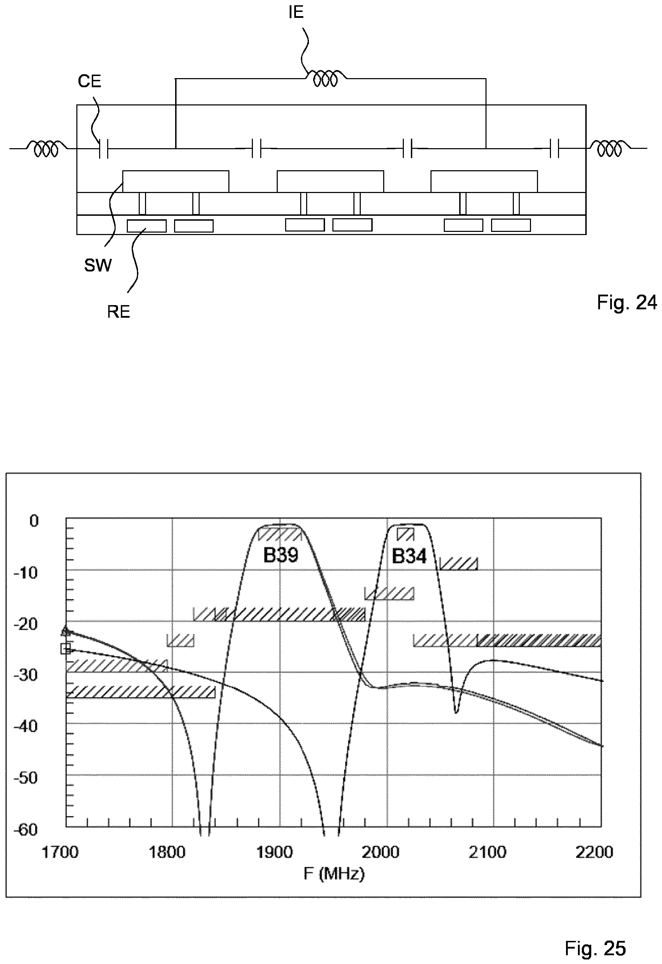

Fig. 24 zeigt, wie Schaltungskomponenten der Filterschaltung vorteilhaft in einem mehrlagigen Modul integriert sein können. Die kapazitiven Elemente CE können als MIM-Kondensatoren (MIM = Metall Isolator Metall) zusammen mit Abschnitten des Signalpfads in einer Lage realisiert sein. Unten an dieser Lage können die Schalter SW realisiert sein. In einer sich darunter befindenden Lage können Durchkontaktierungen geführt sein, die Leitungen einer Schnittstelle zwischen (Halbleiter-) Schaltern und den Resonatorelementen darstellen. Unter der Lage mit der Schnittstelle können dann die Resonatorelemente, z. B. als SAW-, BAW-, GBAW-, ... usw. Elemente, angeordnet sein.

Fig. 25 zeigt berechnete Durchlasskurven für die Bänder 34 und 39, zwischen denen mittel Schalter umgeschaltet werden kann.

HF-Filter oder Duplexer mit HF-Filtern können ferner zusätzliche Resonatoren oder Impedanzelemente, insbesondere abstimmbare Impedanzelemente, umfassen.

Bezugszeichenliste:

| | |
|---|---|
| A: | Admittanz eines Resonators |
| ANT: | Antenne |
| B: | Einfügedämpfung eines HF-Filters |
| B', B1, B2, B3, B4: | Einfügedämpfungen von HF-Filtern |
| CE: | kapazitives Element |
| D: | Duplexer |
| F: | HF-Filter |
| GG: | Grundglied |
| IAS: | Impedanzanpassschaltung |
| IE: | induktives Element |
| IW: | Impedanzwandler |
| J: | Admittanz-Inverter |
| K: | Impedanz-Inverter |
| P: | Parallelresonator |
| R: | Resonator |
| RE: | Resonatorelement |
| RX: | Empfangsfilter |
| S: | Serienresonator |
| SP: | Signalpfad |
| SW: | Schalter |
| TX: | Sendefilter |
| $Z_0$: | charakteristische Leitungsimpedanz |
| $\Phi$: | Phasenversatz |

**Patentansprüche**

1. Duplexer (D), umfassend:

   ein erstes Hochfrequenzfilter (F), wobei das erste Hochfrequenzfilter umfasst:

   - in Serie verschaltete Grundglieder (GG) mit jeweils einem elektroakustischen Resonator (R),
   - in Serie zwischen den Grundgliedern (GG) verschaltete Impedanzwandler (IW),
   wobei
   - die Impedanzwandler (IW) Impedanz-Inverter (K) sind,
   - die Resonatoren (R) der Grundglieder (GG) nur Serienresonatoren (S) sind, und
   - zumindest einer der Resonatoren (R) abstimmbar ist;

   ein zweites Hochfrequenzfilter (F), wobei das zweite Hochfrequenzfilter umfasst:

   - in Serie verschaltete Grundglieder (GG) mit jeweils einem elektroakustischen Resonator (R),
   - in Serie zwischen den Grundgliedern (GG) verschaltete Impedanzwandler (IW),
   wobei
   - die Impedanzwandler (IW) Admittanz-Inverter (J) sind,
   - die Resonatoren (R) der Grundglieder (GG) nur Parallelresonatoren (P) sind, und
   - zumindest einer der Resonatoren (R) abstimmbar ist;

**dadurch gekennzeichnet, dass**

das erste Hochfrequenzfilter als Sendefilter für ein Sendefrequenzband verwendet wird, und das zweite Hochfrequenzfilter als Empfangsfilter für ein Empfangsfrequenzband verwendet wird, wenn das Sendefrequenzband unterhalb des Empfangsfrequenzbandes liegt, oder

das erste Hochfrequenzfilter als Empfangsfilter für ein Empfangsfrequenzband verwendet wird, und das zweite Hochfrequenzfilter als Sendefilter für ein Sendefrequenzband verwendet wird, wenn das Sendefrequenzband oberhalb des Empfangsfrequenzbandes liegt.

2. Duplexer nach dem vorherigen Anspruch, wobei die Impedanzwandler (IW) des ersten und/oder zweiten Hochfrequenzfilters als Impedanzelemente

- kapazitive Elemente (CE) und induktive Elemente (IE) oder
- nur kapazitive Elemente (CE) oder
- nur induktive Elemente (IE)

umfassen.

3. Duplexer nach einem der vorherigen Ansprüche, wobei die Impedanzwandler (IW) des ersten und/oder zweiten Hochfrequenzfilters Phasenschieber-Leitungen umfassen.

4. Duplexer nach einem der vorherigen Ansprüche, ferner umfassend einen zweiten Impedanzwandler (IW), der zu einem Segment entweder des ersten oder des zweiten Hochfrequenzfilters (F) parallel geschaltet ist, wobei das Segment eine Serienschaltung mit einem Grundglied (GG) und zwei Impedanzwandlern (IW) beinhaltet.

5. Duplexer nach einem der vorherigen Ansprüche, wobei der abstimmbare Resonator (R) des ersten Hochfrequenzfilters ein Resonatorelement (RE) und ein abstimmbares Impedanzelement (CE, IE) umfasst, das in Serie oder parallel zum Resonatorelement (RE) verschaltet ist.

6. Duplexer nach einem der Ansprüche 1 bis 4, wobei der abstimmbare Resonator (R) des ersten und/oder zweiten Hochfrequenzfilters ein Feld aus Resonatorelementen (RE) umfasst, von denen jedes Resonatorelement (RE) mittels Schalter (SW) zum Resonator (R) koppelbar ist.

7. Duplexer nach dem vorherigen Anspruch, wobei die Schalter (SW) CMOS-Schalter, auf GaAs basierende Schalter, J-FET oder MEMS-Schalter sind.

8. Duplexer nach einem der vorherigen Ansprüche, wobei alle Resonatoren (R) des ersten und/oder zweiten Hochfrequenzfilters auf verschiedene Frequenzbänder abstimmbar sind.

9. Duplexer nach einem der vorherigen Ansprüche, wobei die Abstimmbarkeit des abstimmbaren Resonators (R) des ersten und/oder zweiten Hochfrequenzfilters eine

- Kompensation einer Temperaturschwankung,
- eine Justierung des des ersten und/oder zweiten Hochfrequenzfilters (F) hinsichtlich einer Impedanzanpassung,
- eine Justierung des des ersten und/oder zweiten Hochfrequenzfilters (F) hinsichtlich einer Einfügedämpfung oder
- eine Justierung des des ersten und/oder zweiten Hochfrequenzfilters (F) hinsichtlich einer Isolation

ermöglicht.

10. Duplexer nach einem der Ansprüche 6 bis 9, wobei jeder Resonator (R) des ersten und/oder zweiten Hochfrequenzfilters gleichviele Resonatorelemente (RE) umfasst, die über Schalter (SW), die über eine MIPI-Schnittstelle ansprechbar sind, steuerbar sind.

11. Duplexer nach einem der vorherigen Ansprüche, das erste Hochfrequenzfilter umfassend

- zwei parallele kapazitive Elemente und

- ein paralleles induktives Element,

wobei die parallelen Elemente in entsprechenden Querzweigen, z.B. gegen Masse, enthalten sind.

12. Duplexer nach einem der Ansprüche 1 bis 10, das erste Hochfrequenzfilter umfassend drei parallele kapazitive Elemente, wobei die parallelen Elemente in entsprechenden Querzweigen, z.B. gegen Masse, enthalten sind.

13. Duplexer nach einem der Ansprüche 1 bis 10, das erste Hochfrequenzfilter umfassend drei parallele induktive Elemente, wobei die parallelen Elemente in entsprechenden Querzweigen, z.B. gegen Masse, enthalten sind.

14. Duplexer nach einem der Ansprüche 1 bis 10, das erste Hochfrequenzfilter umfassend

- zwei parallele induktive Elemente und
- ein paralleles kapazitives Element,

wobei die parallelen Elemente in entsprechenden Querzweigen, z.B. gegen Masse, enthalten sind.

15. Duplexer nach einem der Ansprüche 11 bis 14, wobei das erste Hochfrequenzfilter zwei in Serie verschaltete Grundglieder (GG) und ein kapazitives Element (CE), das parallel zu den zwei in Serie verschalteten Grundgliedern (GG) verschaltet ist, umfasst.


**Claims**

1. A duplexer (D) comprising:

    a first high-frequency filter (F), the first high-frequency filter comprising:

        - basic elements (GG) connected in series with an electroacoustic resonator (R) each,
        - impedance converters (IW) connected in series between the basic elements (GG), wherein
        - the impedance converters (IW) are impedance inverters (K),
        - the resonators (R) of the basic elements (GG) are only series resonators (S), and
        - at least one of the resonators (R) is tunable;

    a second high-frequency filter (F), the second high-frequency filter comprising:

        - basic elements (GG) connected in series with an electroacoustic resonator (R) each,
        - impedance converters (IW) connected in series between the basic elements (GG), wherein
        - the impedance converters (IW) are admittance inverters (J),
        - the resonators (R) of the basic elements (GG) are only parallel resonators (P), and
        - at least one of the resonators (R) is tunable; **characterised in that**

            the first high-frequency filter is used as a transmit filter for a transmit frequency band, and the second high-frequency filter is used as a receive filter for a receive frequency band when the transmit frequency band is below the receive frequency band, or
            the first high-frequency filter is used as a receive filter for a receive frequency band, and the second high-frequency filter is used as a transmit filter for a transmit frequency band when the transmit frequency band is above the receive frequency band.

2. The duplexer according to the preceding claim, wherein the impedance converters (IW) of the first and/or second high-frequency filter are used as impedance elements, comprising

        - capacitive elements (CE) and inductive elements (IE) or
        - only capacitive elements (CE) or
        - only inductive elements (IE).

3. The duplexer according to one of the preceding claims, wherein the impedance converters (IW) of the first and/or second high-frequency filter comprise phase shifter lines.

4. The duplexer according to one of the preceding claims, further comprising a second impedance converter (IW) connected in parallel to a segment of either the first or the second high-frequency filter (F), the segment including a series connection with a basic element (GG) and two impedance converters (IW).

5. The duplexer according to one of the preceding claims, wherein the tunable resonator (R) of the first high-frequency filter comprises a resonator element (RE) and a tunable impedance element (CE, IE) connected in series or in parallel to the resonator element (RE).

6. The duplexer according to one of claims 1 to 4, wherein the tunable resonator (R) of the first and/or second high-frequency filter comprises an array of resonator elements (RE), each resonator element (RE) of which is couplable to the resonator (R) by means of switches (SW).

7. The duplexer according to the preceding claim, wherein the switches (SW) are CMOS switches, GaAs-based switches, J-FET or MEMS switches.

8. The duplexer according to one of the preceding claims, wherein all resonators (R) of the first and/or second high-frequency filter are tunable to different frequency bands.

9. The duplexer according to one of the preceding claims, wherein the tunability of the tunable resonator (R) of the first and/or second high-frequency filter enables

   - compensation of a temperature fluctuation,
   - an adjustment of the first and/or second high-frequency filter (F) with respect to an impedance matching,
   - an adjustment of the first and/or second high-frequency filter (F) with respect to an insertion loss, or
   - an adjustment of the first and/or second high-frequency filter (F) with respect to an isolation.

10. The duplexer according to one of claims 6 to 9, wherein each resonator (R) of the first and/or second high-frequency filter comprises an equal number of resonator elements (RE) controllable via switches (SW) addressable via a MIPI interface.

11. The duplexer according to one of the preceding claims, the first high-frequency filter comprising

   - two parallel capacitive elements and
   - one parallel inductive element,

   wherein the parallel elements are comprised in respective transverse branches, e.g. to ground.

12. The duplexer according to one of claims 1 to 10, the first high-frequency filter comprising three parallel capacitive elements, wherein the parallel elements are comprised in respective transverse branches, e.g. to ground.

13. The duplexer according to one of claims 1 to 10, the first high-frequency filter comprising three parallel inductive elements, wherein the parallel elements are comprised in respective transverse branches, e.g. to ground.

14. The duplexer according to one of claims 1 to 10, the first high-frequency filter comprising

   - two parallel inductive elements and
   - one parallel capacitive element,

   wherein the parallel elements are comprised in respective transverse branches, e.g. to ground.

15. The duplexer according to one of claims 11 to 14, wherein the first high-frequency filter comprises two basic elements (GG) connected in series and one capacitive element (CE) connected in parallel to the two basic elements (GG) connected in series.

**EP 3 183 815 B1**

**Revendications**

1. Duplexeur (D) comprenant :

   un premier filtre haute fréquence (F), le premier filtre haute fréquence comprenant :

      - des éléments de base (GG) montés en série avec chacun un résonateur électroacoustique (R),
      - des transformateurs d'impédance (IW) montés en série entre les éléments de base (GG),

   dans lequel

      - les transformateurs d'impédance (IW) sont des inverseurs d'impédance (K),
      - les résonateurs (R) des éléments de base (GG) ne sont que des résonateurs série (S), et
      - au moins un des résonateurs (R) est accordable ;

   un deuxième filtre haute fréquence (F), le deuxième filtre haute fréquence comprenant :

      - des éléments de base (GG) montés en série avec chacun un résonateur électroacoustique (R),
      - des transformateurs d'impédance (IW) montés en série entre les éléments de base (GG),

   dans lequel

      - les transformateurs d'impédance (IW) sont des inverseurs d'admittance (J),
      - les résonateurs (R) des éléments de base (GG) ne sont que des résonateurs parallèle (P), et
      - au moins un des résonateurs (R) est accordable ;

   **caractérisé en ce que**
   le premier filtre haute fréquence est utilisé comme filtre d'émission pour une bande de fréquences d'émission et le deuxième filtre haute fréquence est utilisé comme filtre de réception pour une bande de fréquences de réception, lorsque la bande de fréquences d'émission se trouve au-dessous de la bande de fréquences de réception, ou
   le premier filtre haute fréquence est utilisé comme filtre de réception pour une bande de fréquences de réception et le deuxième filtre haute fréquence est utilisé comme filtre d'émission pour une bande de fréquences d'émission, lorsque la bande de fréquences d'émission se trouve au-dessus de la bande de fréquences de réception.

2. Duplexeur selon la revendication précédente, dans lequel les transformateurs d'impédance (IW) du premier et/ou du deuxième filtre haute fréquence comprennent comme éléments d'impédance :

      - des éléments capacitifs (CE) et des éléments inductifs (IE), ou
      - seulement des éléments capacitifs (CE), ou
      - seulement des éléments inductifs (IE).

3. Duplexeur selon une des revendications précédentes, dans lequel les transformateurs d'impédance (IW) du premier et/ou du deuxième filtre haute fréquence comprennent des lignes de déphaseur.

4. Duplexeur selon une des revendications précédentes, comprenant en outre un deuxième transformateur d'impédance (IW) qui est monté en parallèle avec un segment soit du premier, soit du deuxième filtre haute fréquence (F), le segment contenant un montage série avec un élément de base (GG) et deux transformateurs d'impédance (IW).

5. Duplexeur selon une des revendications précédentes, dans lequel le résonateur accordable (R) du premier filtre haute fréquence comprend un élément de résonateur (RE) et un élément d'impédance accordable (CE, IE) qui est monté en série ou en parallèle avec l'élément de résonateur (RE).

6. Duplexeur selon une des revendications 1 à 4, dans lequel le résonateur accordable (R) du premier et/ou deuxième filtre haute fréquence comprend un champ d'éléments de résonateur (RE) dont chaque élément de résonateur (RE) est couplable avec le résonateur (R) au moyen de commutateurs (SW).

7. Duplexeur selon la revendication précédente, dans lequel les commutateurs (SW) sont des commutateurs CMOS, des commutateurs à base de GaAs, des J-FET ou des commutateurs MEMS.

8. Duplexeurs selon une des revendications précédentes, dans lequel tous les résonateurs (R) du premier et/ou deuxième filtre haute fréquence sont accordables à diverses bandes de fréquences.

9. Duplexeur selon une des revendications précédentes, dans lequel l'accordabilité du résonateur accordable du premier et/ou second filtre haute fréquence permet :

- une compensation de la variation de température,
- un ajustement du premier et/ou deuxième filtre haute fréquence (F) du point de vue d'une adaptation d'impédance,
- un ajustement du premier et/ou deuxième filtre haute fréquence (F) du point de vue d'un affaiblissement d'insertion ou
- un ajustement du premier et/ou deuxième filtre haute fréquence (F) du point de vue d'une isolation.

10. Duplexeur selon une des revendications 6 à 9, dans lequel chaque résonateur (R) du premier et/ou deuxième filtre haute fréquence comprend le même nombre d'éléments de résonateur (RE) qui sont commandables par l'intermédiaire de commutateurs (SW) sollicitables par l'intermédiaire d'une interface MIPI.

11. Duplexeur selon une des revendications précédentes, dans lequel le premier filtre haute fréquence comprend :

- deux éléments capacitifs parallèles, et
- un élément inductif parallèle,

les éléments parallèles étant contenus dans des branches transversales correspondantes, par exemple à la masse.

12. Duplexeur selon une des revendications 1 à 10, dans lequel le premier filtre haute fréquence comprend trois éléments capacitifs parallèles, les éléments parallèles étant contenus dans des branches transversales correspondantes, par exemple à la masse.

13. Duplexeur selon une des revendications 1 à 10, dans lequel le premier filtre haute fréquence comprend trois éléments inductifs parallèles, les éléments parallèles étant contenus dans des branches transversales correspondantes, par exemple à la masse.

14. Duplexeur selon une des revendications 1 à 10, dans lequel le premier filtre haute fréquence comprend :

- deux éléments inductifs parallèles et
- un élément capacitif parallèle,

les éléments parallèles étant contenus dans des branches transversales correspondantes, par exemple à la masse.

15. Duplexeur selon une des revendications 11 à 14, dans lequel le premier filtre haute fréquence comprend deux éléments de base (GG) montés en série et un élément capacitif (CE) qui est monté en parallèle avec les éléments de base (GG) montés en série.

F

IW    IW    GG, P/S

K$_{S1}$    K$_{12}$    K$_{23}$    K$_{3L}$

S/P    S/P

Fig. 1

P/S    IW    IW    P/S

S/P

Fig. 2

D

TX

RX

ANT

IAS

Fig. 3

Fig. 4

Fig. 5

Fig. 6

Fig. 7

Fig. 8

Fig. 9A

Fig. 9B

Fig. 9C

Fig. 9D

Fig. 9E

Fig. 9F

Fig. 9G

Fig. 9H

Fig. 9I

Fig. 9J

Fig. 9K

Fig. 10A

Fig. 10B

Fig. 11A

Fig. 11B

Fig. 11C

Fig. 11D

Fig. 11E

Fig. 11F

22

Fig. 12A

Fig. 12B

Fig. 12C

Fig. 12D

Fig. 12E

Fig. 12F

IW    R

Fig. 13A

Fig. 13B

Fig. 13C

Fig. 14A

Fig. 14B

Fig. 14C

Fig. 14D

Fig. 14E

Fig. 14F

Fig. 14G

Fig. 14H

Fig. 15A

Fig. 15B

Fig. 15C

Fig. 15D

Fig. 15E

Fig. 15F

Fig. 15G

Fig. 15H

FIG 16

FIG 17

## FIG 18

## FIG 19

## FIG 20

## FIG 21

## FIG 22

## FIG 23

IE

CE

SW

RE

Fig. 24

Fig. 25

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 20120313731 A1
- EP 2530838 A1
- WO 9923757 A1
- EP 1035648 A2

**In der Beschreibung aufgeführte Nicht-Patentliteratur**

- **VON LU.** Reconfigurable Multiband SAW Filters for LTE Applications. *IEEE SiRF 2013,* 153-155